# FASCICULE DE BREVET EUROPEEN

(11) **EP 0 720 293 B1**
(45) Date de publication et mention de la délivrance du brevet: **20.01.1999**
(21) Numéro de dépôt: 95402876.7
(22) Date de dépôt: 19.12.1995
(51) Int. Cl.: H03K 17/96, H03K 17/94

(54) **Codeur multivoie**
Mehrkanalkodierer
Multiple-channel encoder

(30) Priorité: 28.12.1994 FR 9415767
(43) Date de publication de la demande: 03.07.1996
(73) Titulaire: SEXTANT AVIONIQUE (Société Anonyme), 78141 Velizy Villacoublay (FR)
(72) Inventeur: Gaultier, Philippe, F-78150 Le Chesnay (FR); Vouillon, Patrick, F-91140 Villebon sur Yvette (FR); Simon, Frédéric, F-78550 Elancourt (FR)
(74) Mandataire: de Saint-Palais, Arnaud Marie

(56) Documents cités:
- DE-U- 8 910 606
- US-A- 4 054 860
- US-A- 4 408 172

## Description

La présente invention concerne un codeur multivoie permettant d'effectuer des modifications de paramètres d'un processus.

Elle s'applique notamment, mais non exclusivement, à l'équipement de cockpits d'aéronefs. Ainsi. dans ce type d'application, elle peut être avantageusement utilisée pour assurer, par exemple, la commande d'un récepteur ADF (radio compas).

Habituellement, les codeurs simple voie se composent d'un bouton rotatif couplé à une roue codeuse à laquelle est associé un ou plusieurs détecteurs permettant de délivrer une information relative à la position angulaire du codeur et à son sens de rotation.

Bien entendu, la conception de la roue codeuse et des détecteurs qui lui sont associés est fonction du principe de détection mis en oeuvre, lequel peut être de nature électromécanique, magnétique, optique, etc...

Le brevet US 4 408 172 décrit un codeur simple voie utilisable pour effectuer la syntonisation d'un récepteur et/ou émetteur radio et qui comprend un bouton muni d'un contact de doigt qui, lorsqu'il est sollicité, provoque une variation de vitesse de syntonisation.

D'autres codeurs multivoie font, quant à eux, intervenir plusieurs structures de codeurs simple voie agencés de manière à ce que les boutons et les roues codeuses soient disposés coaxialement tout en étant décalés les uns par rapport aux autres.

Les axes des ensembles bouton-roue codeuse sont alors conçus de manière à s'engager coaxialement les uns dans les autres de manière à pouvoir tourner les uns par rapport aux autres.

Avantageusement, ces boutons présentent des diamètres différents, de manière à ce que leur superposition définisse un ensemble de forme conique dans lequel chacun des boutons est identifiable au toucher.

Compte tenu de leur structure et du fait qu'ils nécessitent autant de codeurs que de nombre de voies, les codeurs multivoie sont des appareils relativement coûteux et volumineux.

L'invention a donc plus particulièrement pour but de supprimer ces inconvénients.

Elle propose à cet effet un codeur multivoie du type comportant un bouton couplé à une roue codeuse à laquelle sont associés des moyens de détection de la position angulaire, et éventuellement du sens de rotation de la roue, ce codeur comprenant d'une part, des moyens de sélection de voie incorporés au bouton et comportant des moyens de détection de présence de type capacitif aptes à détecter la présence d'un doigt d'un opérateur sur une zone déterminée du bouton, et d'autre part, des moyens permettant d'associer à l'information délivrée par les susdits moyens de détection, une information relative à la voie qui a été sélectée sur les susdits moyens de sélection, le codeur étant caractérisé en ce que
les susdits moyens de détection de présence comprennent une armature fixe de condensateur solidaire du boîtier du codeur et sur laquelle est appliquée une tension alternative ou impulsionnaire à haute fréquence, et au moins une armature externe de condensateur solidaire du bouton et disposée en regard de l'armature fixe, cette armature étant conçue de manière à pouvoir être amenée en contact électrique avec un doigt de l'opérateur.

Des modes d'exécution de l'invention seront décrits ci-après à titre d'exemples non limitatifs, avec référence aux dessins annexés :
La figure 1 est une vue de la face avant d'un récepteur ADF (radio compas) équipant le poste de pilotage d'un aérodyne ;
La figure 2 est une représentation schématique illustrant un mode de modification d'un paramètre affiché sur un afficheur associé à un codeur à trois voies ;
La figure 3 est une coupe schématique d'un codeur à trois voies de type classique ;
La figure 4 est un premier mode d'exécution d'un codeur à trois voies selon l'invention dans lequel la sélection de voie s'effectue par effet capacitif;
La figure 5 est une variante d'exécution du codeur représenté sur la figure 4 ;
La figure 6 est un schéma synoptique du circuit électronique associé au codeur ;
La figure 7 est un diagramme représentant les niveaux de tension aux bornes du système de condensateur du sélecteur capacitif, selon la nature de la sollicitation du bouton.

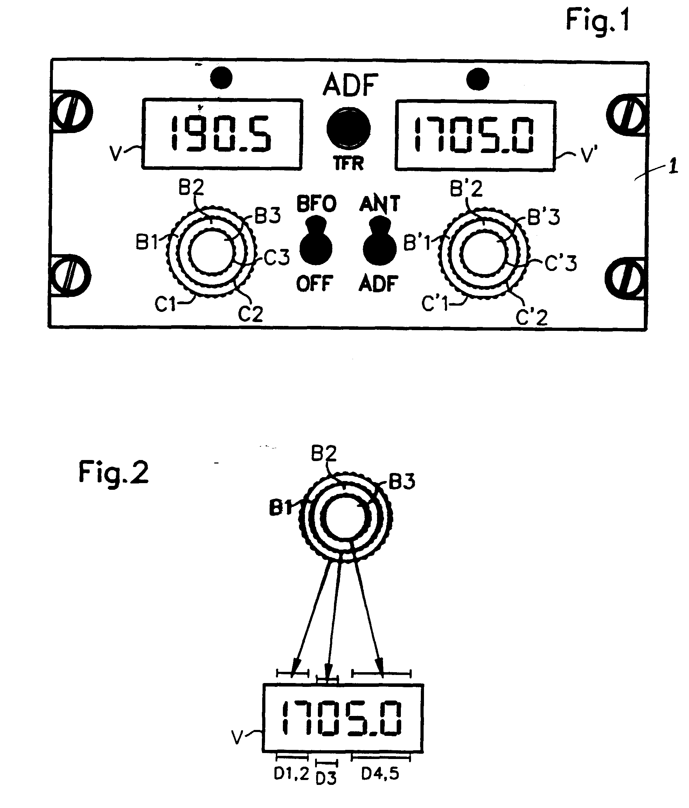

La face avant 1 du récepteur ADF, qui est représentée sur la figure 1, constitue un exemple parmi d'autres, d'utilisation de codeurs dans un tableau de commande d'un cockpit d'aérodyne.

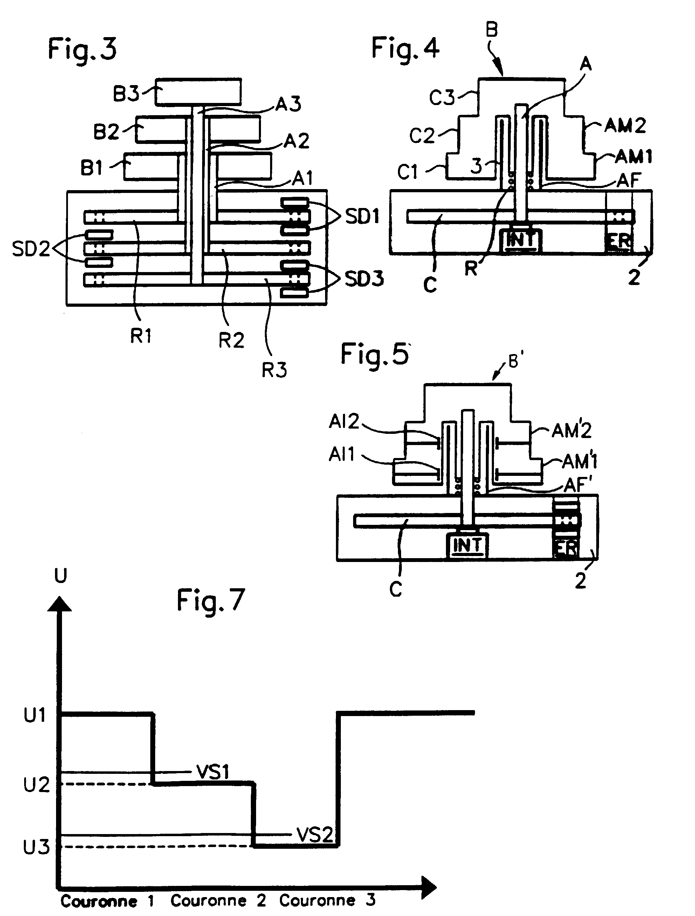

Dans cet exemple, la face avant 1 comprend deux afficheurs V, V' auxquels sont associés deux codeurs respectifs à trois voies, par exemple du type de celui qui se trouve représenté sur la figure 3.

Les boutons B₁, B₂, B₃, B'₁, B'₂, B'₃ de chacun de ces codeurs comprennent trois couronnes cylindriques coaxiales axialement superposées dont les diamètres vont en décroissant (en allant de la première couronne qui est adjacente à la face avant 1 jusqu'à la dernière qui se trouve la plus éloignée de ladite face 1).

La modification d'un paramètre à l'aide de ces codeurs peut s'effectuer digit par digit et/ou par groupes de digits par exemple de la façon indiquée sur la figure 2.

Dans cet exemple, la rotation du bouton B₁ commande une modification (incrémentation ou décrémentation, selon le sens de rotation) des deux premiers digits D_{1,2} affichés sur l'afficheur. Le bouton B₂ est affecté au digit central D₃ tandis que le bouton B₃ commande la modification des deux derniers digits D_{4,5}.

Pour parvenir à ces résultats, la solution utilisée jusqu'ici consiste à utiliser trois boutons indépendants B₁, B₂, B₃ couplés à trois codeurs respectifs au moyen de trois axes coaxiaux s'emboîtant les uns dans les autres, à savoir :
- un axe central A₃ reliant le bouton B₃ à la roue codeuse C₃ du premier codeur ;
- un premier axe tubulaire A₂ monté rotatif autour de l'axe central A₃ et reliant le bouton B₂ à la roue codeuse C₂ du deuxième codeur ;
- un deuxième axe tubulaire A₁ monté rotatif autour du premier axe tubulaire A₂ et reliant le bouton B₁ à la roue codeuse C₁ du troisième codeur.

Bien entendu, à chaque roue codeuse C₁, C₂, C₃ est associé au moins un système de détection SD₁, SD₂, SD₃ faisant intervenir par exemple deux couples émetteur/récepteur d'ondes lumineuses, les roues codeuses C₁, C₂, C₃ étant alors percées d'une multiplicité de trous uniformément répartis sur un cercle concentrique.

Comme précédemment mentionné, l'invention a pour objet une solution, à la fois plus simple, moins coûteuse, plus efficace et se prêtant mieux au traitement numérique des informations.

Elle consiste à utiliser un codeur comprenant une roue codeuse unique C entraînée par un seul bouton B associé à un sélecteur.

Ce bouton B peut être alors conformé de manière à présenter une forme analogue à celle constituée par l'ensemble des trois boutons B₁, B₂, B₃ utilisés dans la solution antérieure.

Ainsi, pour obtenir un codeur analogue à celui représenté sur la figure 3, le bouton B pourra comprendre, comme illustré sur les figures 4, 5, 6, trois couronnes cylindriques coaxiales superposées C₁, C₂, C₃ solidaires les unes des autres et présentant des diamètres différents les uns des autres.

Dans ces exemples, le sélecteur de voies fait intervenir un système capacitif comprenant :
- d'une part, une armature fixe de condensateur AF de forme cylindrique, solidaire du boîtier 2 du codeur, cette armature AF s'engage dans une cavité annulaire coaxiale 3 du bouton B qui débouche au niveau de sa base 4, et
- d'autre part, deux armatures de condensateur AM₁, AM₂ de formes cylindriques, recouvrant respectivement les couronnes cylindriques C₁ et C₂ du bouton B.

Bien entendu, le corps du bouton B est réalisé en un matériau diélectrique tel que, par exemple, une matière plastique moulée.

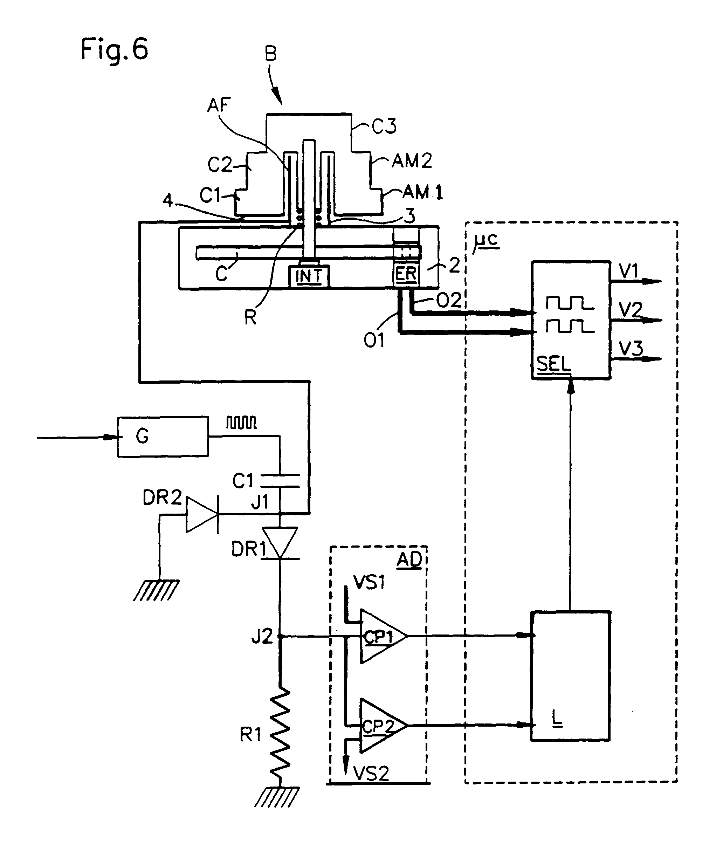

Tel que représenté sur la figure 6, le circuit de sélection de voie associé à ce bouton B fait intervenir un générateur G apte à engendrer un signal périodique de fréquence de l'ordre de quelques MHz, par exemple 4 MHz.

Ce signal est appliqué à un circuit comprenant successivement un condensateur C₁, une diode DR₁ montée en direct et une résistance R₁ reliée à la masse.

Le point de jonction J₁ entre le condensateur C₁ et la diode DR₁ est relié, d'une part, à la masse, par l'intermédiaire d'une diode DR₂ montée en inverse et, d'autre part, à l'armature fixe AF du système capacitif associé au bouton B.

Le point de jonction J₂ entre la diode DR₁ et la résistance R₁ est relié à un circuit de comparaison comprenant au moins deux comparateurs CP₁, CP₂ qui comparent la tension aux bornes de la résistance R₁ à deux tensions de seuil respective VS₁, VS₂.

Les sorties de ces deux comparateurs CP₁, CP₂ sont reliées à un circuit logique L qui effectue la commande d'un sélecteur SEL (multiplexeur) à trois sorties V₁, V₂, V₃ qui correspondent aux trois voies du dispositif.

Le fonctionnement de ce dispositif est alors le suivant :

Dans le cas où seule la couronne C₃ du bouton B est sollicitée, aucune capacité parasite n'est introduite dans le circuit par le système capacitif. La tension U₁ au point de jonction J₂ est alors supérieure au seuil VS₁, les sorties des comparateurs CP₁ et CP₂ sont à l'état 1.1 et, en conséquence, le circuit logique L commande le sélecteur SEL de manière à connecter les sorties O₁, O₂ du codeur à la voie V₁. La rotation du bouton B entraîne donc l'émission sur la voie V₁ d'une information impulsionnaire exploitable par exemple pour commander l'incrémentation ou la décrémentation d'un digit ou d'un groupe de digits d'un paramètre.

Dans le cas où la rotation du bouton B est engendrée par une action sur la couronne C₂, le contact des doigts sur l'électrode cylindrique AM₂ introduit une capacité parasite qui engendre une atténuation du signal fonction de la capacité introduite.

Cette capacité qui est sensiblement proportionnelle à la surface en regard des armatures AM₂ et AF et inversement proportionnelle à la distance qui sépare ces armatures, provoque une chute de tension qui amène la tension au point J₂ à une valeur U₂ inférieure au seuil de tension VS₁ mais supérieure au seuil de tension VS₂. Les sorties des comparateurs CP₁ CP₂ se trouvent alors à l'état logique O₁. Compte tenu de cet état, le circuit logique commande alors le sélecteur SEL de manière à connecter les sorties O₁, O₂ du codeur (codage en position angulaire/sens de rotation) à la voie V₂.

D'une façon analogue, lorsque la rotation du bouton B est engendrée par une action sur la couronne C₁, le contact des doigts sur l'armature cylindrique AM₁ introduit une capacité parasite, par exemple d'une valeur égale à la moitié de la précédente, qui engendre une atténuation de la tension au point J₂ qui passe à une valeur U₃ inférieure au seuil S₂. Les sorties des comparateurs CP₁, CP₂ se trouvent alors à l'état 0.0. Compte tenu de cet état, ce circuit logique L commande alors le sélecteur SEL de manière à connecter les sorties O₁ et O₂ du codeur à la voie V₃.

Bien entendu, l'invention ne se limite pas au mode d'exécution du mode de sélection de voies précédemment décrit. Ainsi, les sorties O₁ et O₂ du codeur pourraient être directement transmises à un microcontrôleur µc indiqué en traits interrompus.

L'information de sélection de voie est alors transmise à ce microcontrôleur µc par un convertisseur analogique/numérique AD (également en traits interrompus) dont l'entrée est connectée au point J₂. Cette solution permet d'associer à chaque information délivrée par le codeur une information d'identification de la voie. Le traitement de ces informations est ensuite effectué par le microcontrôleur µc en fonction du programme applicatif qui lui est associé.

Dans la variante d'exécution représentée figure 5, le système de détection capacitive associé au bouton B' fait intervenir, en plus des armatures externes de condensaAM'₂, AM'₁, des armatures internes annulaires coaxiales AI₂, AI₁ situées à proximité de l'armature fixe AF'.

La surface de ces armatures internes AI₂, AI₁ qui sont respectivement connectées aux armatures externes AM'₂, AM'₁, est alors déterminée de manière à obtenir des écarts de tension U₁ - U₂, U₂ - U₃ et U₁ - U₃, les plus importants possibles, pour diminuer au maximum les risques d'erreur de sélection de voie.

Un avantage des solutions précédemment décrites consiste en ce qu'elles permettent d'adjoindre sans difficulté aux fonctions du bouton, une fonction supplémentaire telle que, par exemple, une fonction de validation.

Il suffit en effet de faire en sorte que l'axe reliant le bouton à la roue codeuse soit mobile axialement de manière à pouvoir actionner un interrupteur INT logé dans le boîtier du codeur. Un ressort de rappel R peut alors être prévu pour maintenir l'interrupteur INT en position de repos et n'obtenir un changement d'état de l'interrupteur INT qu'à la suite d'un effort axial exercé sur le bouton B, à l'encontre de l'action exercée par le ressort R.

Dans les codeurs multivoie précédemment décrits, le fait que le bouton soit monobloc et, qu'en conséquence, les éléments cylindriques en couronne sont solidaires, ne pose pas de problème ergonomique particulier.

En effet, l'opérateur ne regarde pas le codeur pendant son utilisation mais le paramètre qu'il modifie et qui est indiqué sur l'afficheur.

Par ailleurs, grâce aux dispositions précédemment décrites, le microcontrôleur ou éventuellement le processeur qui lui est associé, peut commander des moyens de signalisation permettant d'indiquer à l'opérateur la fonction de la couronne qui est touchée avant même qu'elle soit actionnée. Cette signalisation peut, par exemple, consister en une modification graphique du parai mètre affiché telle que, par exemple, une surbrillance, une vidéo inverse, une modification de la couleur, un clignotement. Cette signalisation pourrait être également assurée au moyen d'une information sonore telle que, par exemple, un message vocal obtenu par synthèse vocale.

## Revendications

1. Codeur multivoie du type comprenant un bouton (B) couplé à une roue codeuse (C) à laquelle sont associés des moyens de détection (ER) de la position angulaire et, éventuellement, du sens de rotation de la roue (C), ce codeur comprenant, d'une part, des moyens de sélection de voie (AF, AM₂, AM₁) incorporés au bouton (B) et comportant des moyens de détection de présence de type capacitif aptes à détecter la présence d'un doigt d'un opérateur sur une zone déterminée du bouton (B) et, d'autre part, des moyens permettant d'associer à l'information délivrée par les susdits moyens de détection (ER), une information relative à la voie (V₁ à V₃) qui a été sélectée sur les susdits moyens de sélection (AF, AM₂, AM₁),
caractérisé en ce que les susdits moyens de détection de présence (AF, AM₂, AM₁) comprennent une armature fixe de condensateur (AF) solidaire d'un boîtier (2) du codeur et sur laquelle est appliquée une tension alternative ou impulsionnaire à haute fréquence, et au moins une armature externe de condensateur (AM₂, AM₁) solidaire du bouton (B) et disposée en regard de l'armature fixe (AF), cette armature externe étant conçue de manière à pouvoir être amenée en contact électrique avec un doigt de l'opérateur.

2. Codeur selon la revendication 1,
caractérisé en ce que la susdite armature externe (AM₂, AM₁) présente une forme cylindrique et recouvre une couronne (C₂, C₃) du bouton (B).

3. Codeur selon la revendication 2,
caractérisé en ce que l'armature externe (AM'₂, AM'₁) est reliée à une armature interne (AI₂, AI₁) plus rapprochée de l'armature fixe (AF').

4. Codeur selon l'une des revendications précédentes,
caractérisé en ce que l'armature fixe (AF) présente une forme tubulaire cylindrique et s'engage dans une cavité annulaire (3) coaxiale formée dans le bouton (B) et qui débouche au niveau de sa base (4).

5. Codeur selon l'une des revendications précédentes,
caractérisé en ce que le bouton (B) comprend trois couronnes (C₁, C₂, C₃) de diamètre différent dont deux seulement sont revêtues d'une armature externe de condensateur (AM₂, AM₁) éventuellement associée à deux armatures internes respectives (AI₂, AI₃).

6. Codeur selon l'une des revendications 1 à 4,
caractérisé en ce que les susdits moyens de sélection de voies comprennent au moins un comparateur (CP₁, CP₂) apte à comparer la tension (U) appliquée à l'armature fixe (AF) à une valeur de seuil (VS₁, VS₂) et un circuit logique (L) associé à un sélecteur de voies (SEL) qui reçoit les informations émanant des susdits moyens de détection (ER) et qui les transmet sur une voie (V₁, V₂, V₃) selon le niveau de ladite tension (U).

7. Codeur selon l'une des revendications 1 à 4,
caractérisé en ce que les susdits moyens de sélection comprennent un convertisseur analogique/numérique (AD) qui reçoit un signal représentatif de la tension (U) appliquée à l'armature fixe (AF) et qui transmet un signal numérique correspondant à un microcontrôleur (µc) qui reçoit les informations délivrées par les moyens de détection (ER) du codeur.

8. Codeur selon l'une des revendications précédentes,
caractérisé en ce qu'il comprend des moyens de signalisation, par exemple lumineux ou sonore, de la voie sélectée.

9. Codeur selon l'une des revendications précédentes,
caractérisé en ce que l'ensemble comprenant le bouton (B), la roue codeuse (C) et l'axe d'accouplement (A), est mobile axialement avec rappel par ressort (R), de manière à pouvoir actionner un interrupteur (INT) en exerçant sur le bouton (B) une force antagoniste à l'action du ressort (R).

## Patentansprüche

1. Mehrkanal-Codierer vom Typ mit einem Schaltknopf (B), der mit einem Codierrad (C) gekoppelt ist, an das Sensoren für die Feststellung (ER) der Winkelposition und eventuell der Drehrichtung des Rades (C) angeschlossen sind, wobei dieser Codierer zum einen Mittel für die Wahl des Kanals (AF, AM2, AM1) beinhaltet, die in den Schaltknopf (B) integriert sind und Sensoren für die Präsenzfeststellung (-) beinhalten, die in der Lage sind, die Präsenz eines Fingers eines Bedieners in einer bestimmten Zone des Schaltknopfes (B) festzustellen, und zum anderen Mittel, die es erlauben, der von den genannten Sensoren (ER) übermittelten Information eine Information in bezug auf den Kanal (V1 bis V3) zuzuordnen, der anhand der genannten Auswahlmittel (AF, AM2, AM1) ausgewählt worden ist,
dadurch gekennzeichnet, daß die genannten Sensoren für die Präsenzfeststellung (AF, AM2, AM1) vom kapazitiven Typ eine feste Kondensatorummantelung (AF) beinhalten, die mit dem Gehäuse (2) des Codierers verbunden ist und an die eine hochfrequente Wechselspannung oder Impulsspannung angelegt wird, und mindestens eine externe Kondensatorummantelung (AM2, AM1), die fest mit dem Schaltknopf (B) verbunden und gegenüber der festen Ummantelung (AF) angeordnet ist, wobei diese externe Ummantelung so konzipiert ist, daß sie mit einem Finger des Bedieners in elektrischen Kontakt gebracht werden kann.

2. Codierer gemäß Patentanspruch 1,
dadurch gekennzeichnet, daß die obengenannte externe Ummantelung (AM2, AM1) eine zylindrische Form besitzt und einen Kranz (C2, C3) des Schaltknopfes (B) überdeckt.

3. Codierer gemäß Patentanspruch 2,
dadurch gekennzeichnet, daß die externe Ummantelung (AM'2, AM'1) an eine interne Ummantelung (AI2, AI1) angeschlossen ist, die sich näher an der feststehenden Ummantelung (AF) befindet.

4. Codierer gemäß einem der voranstehenden Patentansprüche,
dadurch gekennzeichnet, daß die feststehende Ummantelung (AF) eine röhrenförmige, zylindrische Form besitzt und in einer koaxialen ringförmigen Vertiefung (3) in dem Schaltknopf(B) sitzt und in Höhe seiner Basis mündet (4).

5. Codierer gemäß einem der voranstehenden Patentansprüche,
dadurch gekennzeichnet, daß der Schaltknopf (B) drei Kränze (C1, C2, C3) unterschiedlichen Durchmessers beinhaltet, von denen nur zwei mit einer externen Kondensatorummantelung (AM2, AM1) beschichtet sind, die eventuell mit zwei entsprechenden internen Ummantelungen (AI1, AI2) verbunden ist.

6. Codierer gemäß einem der Patentansprüche 1 bis 4, dadurch gekennzeichnet, daß die genannten Mittel für die Kanalwahl mindestens einen Komparator (CP1, CP2) beinhalten, der in der Lage ist, die Spannung (U), die an die feststehende Ummantelung (AF) angelegt wird, mit einem Schwellenwert (VS1, VS2) zu vergleichen, und einen Logikschaltkreis (L), der mit einem Kanalwähler (SEL) verbunden ist, der die Informationen empfängt, die von den genannten Sensoren (ER) ausgehen und der sie je nach Höhe der genannten Spannung (U) an einen Kanal (V1, V2, V3) übermittelt.

7. Codierer gemäß einem der Patentansprüche 1 bis 4, dadurch gekennzeichnet, daß die genannten Mittel für die Kanalwahl einen Analog/Digitalwandler (AD) beinhalten, der ein Signal empfängt, das für die Spannung (U) steht, die an die feststehende Ummantelung (AF) angelegt wird und der ein entsprechendes digitales Signal an einen Mikrocontroller (µc) übermittelt, der die Informationen aufnimmt, die von den Sensoren (ER) des Codierers abgegeben werden.

8. Codierer gemäß irgendeinem der vorangegangenen Patentansprüche,
dadurch gekennzeichnet, daß er Anzeigevorrichtungen, zum Beispiel optischer oder akustischer Art, für die Anzeige des gewählten Kanals beinhaltet.

9. Codierer gemäß einem der vorangegangenen Patentansprüche,
dadurch gekennzeichnet, daß die Baugruppe aus Schaltknopf (B), Codierrad (C) und Kupplungsachse (A) axial beweglich ist, mit einer Rückholfeder (R), so daß sich ein Schalter (INT) betätigen läßt, indem auf den Schaltknopf (B) eine Kraft ausgeübt wird, die sich antagonistisch zur Wirkung der Feder (R) verhält.

## Claims

1. A multichannel coder of the type comprising a knob (B) coupled with a code wheel (C) associated with a means (ER) of detecting the angular position and, possibly, the direction of rotation of the wheel (C), said coder comprising, on the one hand, a channel selection means (AF, AM₂, AM₁) incorporated into the knob (B) and comprising a capacitive-type presence detection means capable of detecting the presence of a finger of an operator on a given zone of the knob (B), and, on the other hand, a means enabling the association, with the information provided by said detection means (ER), of a datum concerning the channel (V₁ to V₃) that has been selected on said selection means (AF, AM₂, AM₁), characterized in that said presence detection means (AF, AM₂, AM₁) comprises a fixed armament of a capacitor (AF) integral with the case (2) of the coder and to which is applied a highfrequency alternating or pulsed voltage, and at least one external armament of a capacitor (AM₂, AM₁) integral with the knob (B) and disposed opposite said fixed armament (AF), said external armament being designed so as to be susceptible of being brought into electrical contact with one of the operator's fingers.

2. The coder as claimed in claim 1, characterized in that said external armament (AM₂, AM₁) is cylindrically shaped and covers a ring (C₂, C₃) of said knob (B).

3. The coder as claimed in claim 2, characterized in that said external armament (AM'₂, AM'₁) is connected to an internal armament (AI₂, AI₁) closer to said fixed armament (AF').

4. The coder as claimed in one of the preceding claims, characterized in that said fixed armament (AF) is of cylindrical tubular shape and fits into a coaxial annular cavity (3) formed in said knob (B) and which opens out at the level of its base (4).

5. The coder as claimed in one of the preceding claims, characterized in that said knob (B) comprises three rings (C₁, C₂, C₃) of different diameter of which only two are covered with an external armament of a capacitor (AM₂, AM₁), possibly associated with two respective internal armaments (AI₂, AI₃).

6. The coder as claimed in one of claims 1 to 4, characterized in that said channel selection means comprises at least one comparator (CP₁, CP₂) capable of comparing the voltage (U) applied to said fixed armament (AF) with a threshold value (VS₁, VS₂), and a logic circuit (L) associated with a channel selector (SEL) which receives the data output by said detection means (ER) and transmits them along a channel (V₁, V₂, V₃) according to the level of said voltage (U).

7. The coder as claimed in one of claims 1 to 4, characterized in that said selection means comprises an analog-to-digital converter (AD) which receives a signal that is representative of the voltage (U) applied to said fixed armament (AF) and which transmits a corresponding digital signal to a microcontroller (µc) which receives the data provided by said detection means (ER) of said coder.

8. The coder as claimed in one of the preceding claims, characterized in that it comprises a means, e.g. luminous or sonorous, for signaling the channel selected.

9. The coder as claimed in one of the preceding claims, characterized in that the unit comprising the knob (B), the code wheel (C) and coupling axis (A), is axially mobile with a retracting spring (R) in order for it to be able to operate a switch (INT) by exerting on the knob (B) a force opposing the action of the spring.
